Europäisches Patentamt

European Patent Office

Office européen des brevets

(11) Numéro de publication : **0 636 894 A1**

## (12) DEMANDE DE BREVET EUROPEEN

(21) Numéro de dépôt : **94401237.6**

(22) Date de dépôt : **03.06.94**

(51) Int. Cl.⁶ : **G01R 31/28**

(30) Priorité : **03.06.93 FR 9306667**

(43) Date de publication de la demande :
**01.02.95 Bulletin 95/05**

(84) Etats contractants désignés :
**DE GB**

(71) Demandeur : **MATRA CAP SYSTEMES**
**37, avenue Louis-Bréguet**
**F-78140 VELIZY-VILLACOUBLAY (FR)**

(72) Inventeur : **Samson, Didier**
**c/o MATRA CAP SYSTEMES,**
**37, avenue Louis Bréguet**
**F-78140 Velizy Villacoublay (FR)**

(74) Mandataire : **Fort, Jacques**
**CABINET PLASSERAUD**
**84, rue d'Amsterdam**
**F-75440 Paris Cedex 09 (FR)**

(54) **Circuit et procédé de contrôle des pistes d'un circuit d'interconnexion.**

(57)   Suivant le procédé on dépose, sur le substrat diélectrique (10) portant les pistes (14), au moins deux motifs capacitifs de test $(16_1, 16_2)$ ayant des surfaces différentes $(S_1, S_2)$ et un motif conducteur de test (18) ayant la même largeur que les pistes,

on mesure les capacités $(C_1, C_2, C_r)$ des motifs capacitifs et conducteur,

à partir des capacités $(C_1, C_2)$ des motifs capacitifs on calcule l'épaisseur (e) du substrat diélectrique (e) entre lesdits motifs et le plan de masse et la constante diélectrique $(\varepsilon)$,

à partir de la capacité du motif conducteur $(C_r)$ et de la constante diélectrique on calcule la surface du motif conducteur et on en déduit la largeur des pistes, et

on mesure la capacité de chaque piste de liaison équipotentielle à contrôler et on la compare à la capacité théorique de ladite liaison équipotentielle.

FIG.1.

EP 0 636 894 A1

La présente invention concerne les circuits d'interconnexion destinés à recevoir des composants micro électroniques et elle trouve une application particulièrement importante, bien que non exclusive, dans le cas de circuits d'interconnexion destinés à constituer des ensembles complexes de hautes performances, ayant des pistes conductrices très étroites et une densité d'interconnexion élevée et destinés à recevoir des composants coûteux.

Il est difficile de tester l'ensemble des pistes conductrices de liaison équipotentielle d'un circuit d'interconnexion réalisé sur un substrat lorsque la densité d'interconnexion est très élevée et que les pistes sont très étroites, et cela est même impossible lorsque certaines pistes sont enterrées. Cela conduit à monter les composants avant de faire les contrôles sur l'ensemble complet. Un défaut d'interconnexion éventuel n'est alors révélé qu'à la fin des opérations d'assemblage, ce qui conduit à rejeter l'ensemble défectueux alors que tous les coûts de fabrication ont été exposés.

L'invention vise notamment à fournir un procédé de contrôle des pistes conductrices autorisant la vérification de la continuité des liaisons équipotentielles avant montage des composants.

L'invention propose dans ce but un procédé de contrôle des pistes conductrices de liaison équipotentielle d'un circuit d'interconnexion déposé sur un substrat diélectrique comportant un plan de masse, destiné à recevoir des composants micro électroniques, suivant lequel :

(a) on dépose, sur le substrat diélectrique portant les pistes, en même temps que lesdites pistes, au moins deux motifs capacitifs de test ayant des surfaces différentes et un motif conducteur de test ayant la même largeur que les pistes,

(b) on mesure les capacités ($C_1$, $C_2$, $C_r$) des motifs capacitifs et conducteur,

(c) à partir des capacités ($C_1$, $C_2$) des motifs capacitifs on calcule la constante diélectrique ($\varepsilon$) du substrat diélectrique du substrat,

(d) à partir de la capacité du motif conducteur ($C_r$) et de la constante diélectrique on calcule la surface du motif conducteur et on en déduit la largeur des pistes, et

(e) on mesure la capacité de chaque piste de liaison équipotentielle à contrôler et on la compare à une capacité théorique de ladite liaison équipotentielle tenant compte des valeurs réelles de la constance diélectrique et de la largeur, précédemment déterminées (cette capacité théorique pouvant être déterminée à partir de sa longueur, connue, et des valeurs réelles de la constante diélectrique et de la largeur, précédemment déterminées, et/ou à partir de mesures sur un circuit d'interconnexion réputé bon).

Tout écart significatif entre la capacité mesurée et la capacité attendue révèle une coupure de la piste ou la mise en court-circuit de deux pistes.

On voit que le procédé utilise le fait que les variations de longueur des pistes équipotentielles d'un même lot sont suffisamment faibles pour qu'elles soient négligeables et que l'on peut déterminer la capacité théorique de chaque liaison équipotentielle à partir de cette longueur et de valeurs mesurées des paramètres physiques susceptibles de varier.

Il est par ailleurs de plus en plus souhaitable, notamment sur des circuits complexes ou devant assurer une sécurité absolue, de connaître parfaitement les paramètres physiques des éléments conducteurs et diélectriques du circuit d'interconnexion. D'une part cela permet de prédire les performances du circuit et notamment sa vitesse maximale de fonctionnement possible. D'autre part, cela permet, en surveillant l'évolution des caractéristiques et en effectuant un suivi statistique, d'intervenir sur une chaîne de fabrication avant que la dégradation d'une caractéristique ne conduise à rebuter les circuits obtenus.

Un autre aspect de l'invention permet, sans compliquer notablement le procédé de contrôle, de déterminer également l'épaisseur des pistes.

Pour cela :

(f) on mesure également la résistance du motif, et

(g) à partir de cette résistance, de la largeur précédemment déterminée ainsi que de la résistivité du matériau constitutif de la piste et de sa longueur, l'une et l'autre connues a priori, on calcule l'épaisseur de métallisation qui -du fait que la métallisation est effectuée globalement- est également celle des pistes équipotentielles, ou du moins celle des pistes situées à proximité du motif conducteur.

Les valeurs de la largeur et de l'épaisseur des pistes mesurées sur des circuits fabriqués successivement peuvent être mémorisées et traitées pour déterminer leur évolution. Il est ainsi possible de modifier des paramètres de fabrication avant que la dégradation d'une caractéristique conduise à rebuter systématiquement des cartes.

L'invention propose également un circuit permettant de mettre en oeuvre le procédé ci-dessus défini. Un tel circuit comporte, en plus de pistes conductrices de liaison équipotentielle ménagées sur un substrat diélectrique comportant un plan de masse,

- au moins deux motifs capacitifs de test ayant des surfaces différentes, reliées à des plots de référence,
- au moins un motif conducteur de test ayant la même largeur que les pistes conductrices et la même constitution, dont les extrémités sont reliées à des plots de référence placés à proximité des premiers, et
- des plots de signal, reliés chacun à l'une des pistes conductrices de liaison équipotentielle et placés à proximité des autres plots.

Dans un premier mode de réalisation du circuit, ce dernier porte également un microcomposant de mesure et de contrôle ayant des entrées d'alimentation, deux plages d'entrée-sortie de signal et des plages raccordées chacune à l'un desdits plots et le microcomposant contient des cellules de mesure analogique d'au moins la capacité des différentes pistes et motifs et des moyens de multiplexage, permettant de fournir les mesures effectuées à des moyens extérieurs.

Plusieurs microcomposants du type ci-dessus défini peuvent être répartis sur le même substrat.

Une telle constitution permet d'effectuer les mesures et vérifications requises à l'aide d'une tête de test comportant uniquement quatre pointes de liaison, destinées à s'appliquer sur des plages prévues à cet effet sur le substrat et raccordés à des plots d'entrée-sortie et d'alimentation du microcomposant actif de contrôle et de mesure.

Il est toutefois également possible d'intégrer le microcomposant actif dans une tête de test, en munissant cette dernière d'autant d'aiguilles de contact qu'il y a de plots reliés aux pistes de liaisons équipotentielles et aux motifs.

L'invention sera mieux comprise à la lecture de la description qui suit de modes particuliers de réalisation donnés à titre d'exemples non-limitatifs. La description se réfère aux dessins qui l'accompagnent, dans lesquels :

- la figure 1 montre, en perspective, un fragment de circuit imprimé d'interconnexion portant un microcomposant de contrôle et de mesure permettant d'acquérir, depuis l'extérieur, des informations nécessaires à la caractérisation du circuit imprimé à partir d'un nombre restreint de plages de contact ;
- la figure 2 est une vue en plan montrant une répartition possible des plots de sortie du microcomposant de la figure 1 ;
- la figure 3 montre la variation de la capacité C d'une piste ou d'un motif en fonction de sa surface S;
- la figure 4 est un synoptique donnant une séquence possible des opérations de test sur un circuit imprimé ;
- la figure 5 est un synoptique des fonctions implémentées dans un microcomposant de mise en oeuvre de l'invention.

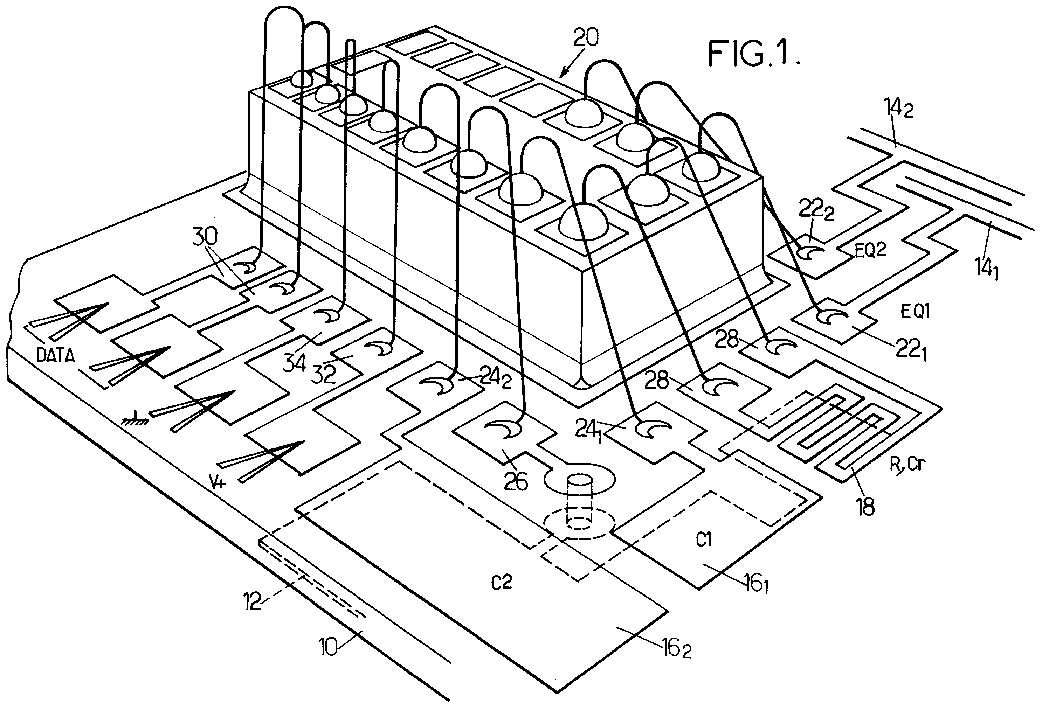

Le circuit d'interconnexion dont un fragment est montré en figure 1 peut être constitué sur l'un quelconque des substrats habituels, tels que carte en verre-époxy, carte à haute densité, substrat céramique, co-cuit céramique. Le procédé mis en oeuvre reste le même dans tous les cas, mais les ordres de grandeur des valeurs sont différents, en particulier les capacités, de sorte que des microcomposants différents seront nécessaires pour mettre en oeuvre l'invention sur différents substrats.

Le substrat 10 est muni d'un plan de masse 12, souvent enterré. Il est souvent également muni d'un plan d'alimentation constitué de pistes répartissant une tension de fonctionnement.

Sur au moins une face du substrat, et éventuellement dans des plans internes, sont réalisés des tracés équipotentiels sous forme de pistes métalliques conductrices ayant une épaisseur et une largeur nominales qui peuvent être très faibles. Une largeur de 25 $\mu$m est maintenant courante. Toutes les pistes étant réalisées simultanément, elles ont la même épaisseur e. Chacune des pistes a une capacité totale déterminée par rapport au plan de masse 12. Cette capacité peut varier d'un circuit à l'autre, lors de la fabrication de circuits nominalement identiques. Par exemple, les largeurs varient ; la constante diélectrique du matériau constitutif du substrat peut varier d'un lot à un autre. La constante diélectrique peut également évoluer dans le temps. En revanche, la longueur des pistes ne varie pas de façon significative et, au cours d'une même étape de métallisation, l'épaisseur du dépôt varie peu d'un point à un autre.

Le circuit d'interconnexion dont une fraction est montrée schématiquement en figure 1 comporte un substrat 10 dont l'épaisseur e de diélectrique entre les pistes et le plan de masse 12 est une donnée qui peut être fournie par le fabricant. Deux des pistes métallisées de liaison équipotentielle, $14_1$ et $14_2$, sont représentées partiellement sur la figure 1.

Pour permettre la mise en oeuvre de l'invention le substrat porte également trois motifs, réalisés en même temps que les pistes conductrices :

- deux motifs capacitifs $16_1$ et $16_2$, constitués par exemple par des zones métallisées rectangulaires, de surfaces respectives S1 et S2 connues
- un motif conducteur 18, constitué par une piste de même largeur que les pistes de liaisons équipotentielles.

Sur le substrat sont également déposés des plots permettant d'effectuer des mesures sur les pistes et les motifs, à partir d'une zone déterminée de la carte.

Dans le cas illustré sur la figure 1, ces mesures sont effectuées en mettant en oeuvre un microcomposant actif rapporté 20. Les plots de raccordement sont alors réparties autour de l'emplacement de ce microcomposant. Ils comportent, dans le cas illustré :

- des plots de signal $22_1$, $22_2$, .... reliés chacun à une des pistes $14_1$, $14_2$, ........,
- des plots $24_1$ et $24_2$ reliés aux motifs capacitifs,
- un plot 26 relié au plan de masse, et permettant des mesures de capacité,
- deux plots 28 reliés aux extrémités du motif conducteur 18 et permettant de mesurer la résistance et la capacité de ce dernier.

Afin de réduire le nombre des points qui doivent recevoir les aiguilles d'une tête de test sur le circuit, le micro-composant 20 est prévu pour effectuer des mesures de capacité et de résistance et un traitement partiel de ces mesures. Ses liaisons avec l'extérieur peuvent alors être limitées à quatre et être matérialisées par :

- des plots métallisés 30 d'entrée-sortie de données,
- un plot 32 d'amenée de tension d'alimentation +V,
- un plot 34 de liaison de masse avec l'extérieur.

Les liaisons entre les plots et les plages de sortie du microcomposant sont représentées sur la figure 1 sous forme de tronçons de fils souples. Mais le microcomposant pourrait également être réalisé pour permettre d'autres modes de liaisons, par exemple par fixation à plat avec soudure directe de ses plages de sortie, situées uniquement à la périphérie ou répartis sur sa surface, c'est-à-dire en mettant en oeuvre le procédé dit "flip chip".

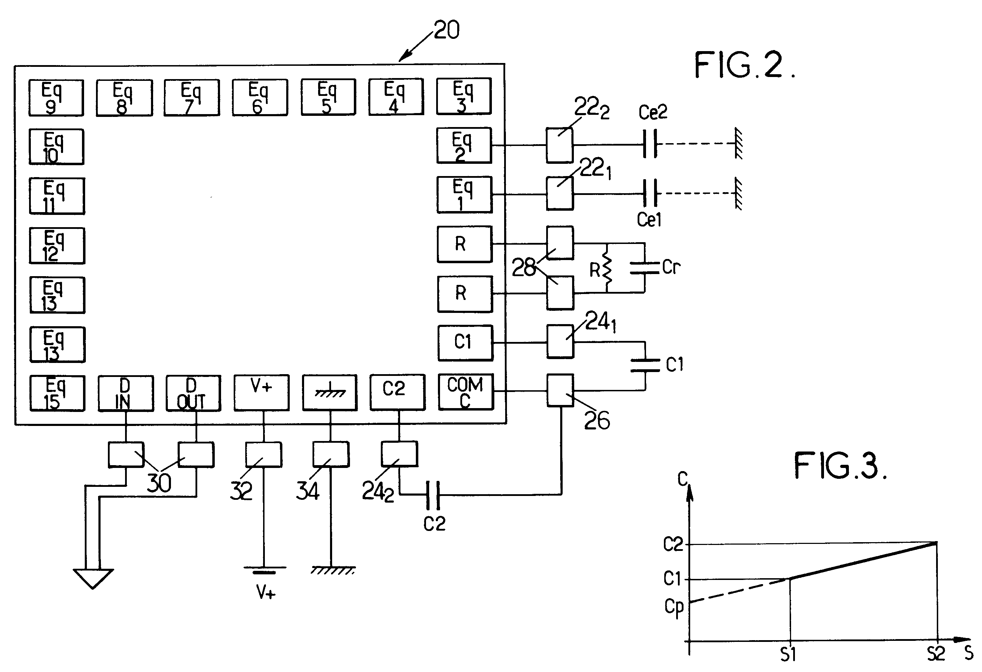

Sur la figure 2, une répartition possible des bornes de sortie d'un microcomposant 20 est donnée à titre d'exemple les plages désignées par $E_{q1}$, $E_{q2}$, ..., $E_{q15}$ sont destinées à être reliées chacune à une piste de liaison équipotentielle. Les capacités des deux premières sont indiquées schématiquement et désignées $Ce_1$ et $Ce_2$.

Le procédé est alors mis en oeuvre de la façon suivante.

Une première série de mesures permet de caractériser l'ensemble du circuit.

Pour cela on mesure les capacités $C_1$ et $C_2$ des motifs $16_1$ et $16_2$, auxquels on a donné des surfaces différentes et connues $S_1$ et $S_2$.

On peut ainsi tracer ou mémoriser la loi de variation de la capacité C en fonction de la surface S du motif. Cette loi, représentée sur la figure 3, peut s'écrire :

C = $C_p$ + AS

où $C_p$ est la capacité parasite de liaison, qui est la même pour $C_1$ et $C_2$. Le coefficient A est proportionnel à la constante diélectrique $\varepsilon$ du matériau constitutif du substrat et inversement proportionnel à la distance connue e entre les motifs et le plan de masse; qui est la même pour les deux capacités $C_1$ et $C_2$. On peut en conséquence calculer la constante diélectrique $\varepsilon$ de la connaissance de $\varepsilon$, $S_1$, $S_2$, $C_1$, $C_2$.

Les mesures de caractérisation comportent également la mesure de la capacité $C_r$ du motif conducteur 18. Elle permet, à partir de la même mesure effectuée sur un motif identique, réputé bon et placé sur un substrat de référence, de calculer la largeur w des pistes. En effet le rapport des surfaces de deux motifs conducteurs, de même longueur, est égal au rapport des capacités, une fois effectuées des corrections tenant compte des écarts sur l'épaisseur e et la constante diélectrique. Le rapport des surfaces est à son tour égal au rapport des largeurs entre le motif sur lequel est effectuée la mesure et le motif de référence.

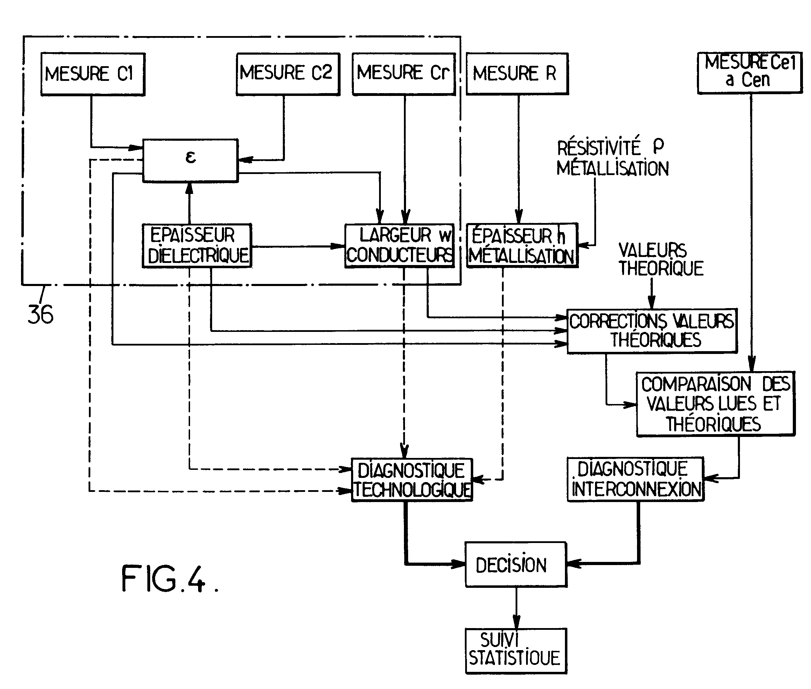

Ces mesures préliminaires de caractérisation, indiquées en 36 sur la figure 4 permettent d'effectuer ensuite des contrôles sur les pistes de liaison équipotentielle. On mesure la capacité de chacune de ces pistes, par exemple $Ce_1$ pour $14_1$. Cette capacité est comparée à la capacité $C_{R1}$ mesurée sur un circuit de référence réputé bon, après une correction tenant compte des écarts sur l'épaisseur e de constante diélectrique, la largeur w des pistes et la constante diélectrique $\varepsilon$ entre le circuit de référence et le circuit contrôlé.

Lorsque la capacité mesurée s'écarte de la capacité théorique, corrigée pour tenir compte de la valeur réelle des paramètres physiques, on peut conclure à un défaut de la piste qui est :

- un court-circuit si la capacité est excessive,
- une coupure si la capacité est trop faible.

Dans le cas illustré sur la figure 4, un diagnostic est effectué à partir des comparaisons pour toutes les pistes et une décision de conservation ou de rejet du circuit est prise.

Le diagnostic portant sur l'interconnexion peut être complété par un diagnostic portant sur le respect de caractéristiques nominales mémorisées.

Ce diagnostic peut prendre en compte la valeur de la constante diélectrique et la largeur w des pistes.

Il peut être complété par un contrôle portant sur l'épaisseur h des pistes. Pour cela, la résistance R du motif conducteur 18 est mesurée. La résistivité du matériau de métallisation utilisé étant connue ainsi que la longueur du motif et sa largeur w, l'épaisseur h de métallisation peut en être déduite. Elle est égale à :

$$h = 1.\rho/w.R$$

où 1 est la longueur, $\rho$ la résistivité, R la résistance et w la largeur.

Là encore, une décision quant au rejet ou à l'acceptation peut être effectuée, en fonction de la déviation des valeurs mesurées par rapport aux valeurs nominales.

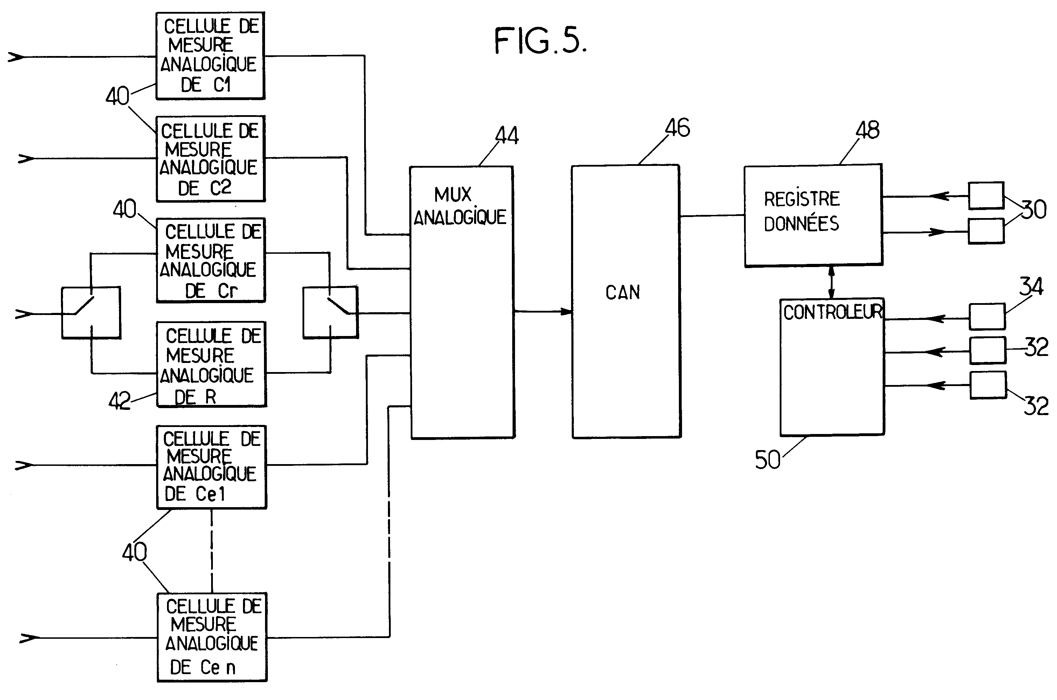

Le microcomposant peut avoir la constitution définie par le schéma synoptique de la figure 5. Il comporte alors une cellule 40 de mesure analogique de capacité pour chaque motif et chaque piste et il comporte de plus une cellule 42 de mesure analogique de la résistance du motif 18. Un multiplexeur analogique 44 permet d'aiguiller les signaux de mesure vers la sortie. Ces signaux sont mis sous forme numérique par un convertisseur analogique-numérique 46, et mémorisés dans un registre de données 48. Un contrôleur 50, relié aux entrées d'alimentation et éventuellement à une entrée de commande supplémentaire 52 peut être prévu pour provoquer l'ensemble des mesures en suivant une séquence déterminée et effectuer les calculs nécessaires.

Dans le mode de réalisation montrée sur les figures 1 et 2, le nombre de pistes qu'il est possible de contrôler est limité par le nombre maximum de plots de contact réalisables à la périphérie du microcomposant. Ce nombre peut être augmenté en utilisant la technologie de montage dite "flip-chip", qui de plus réduit la surface nécessaire pour implanter les fonctions sur le circuit.

Dans une variante de réalisation, qui exige l'emploi d'aiguilles de contact non susceptibles d'endommager les plages de liaison, le microcomposant est reporté dans une tête de test.

L'invention ne se limite pas aux modes particuliers de réalisation qui ont été représentés et décrits à titre d'exemples et elle est susceptible d'être réalisée sous d'autres formes encore.

## Revendications

1. Procédé de contrôle des pistes conductrices de liaison équipotentielle d'un circuit d'interconnexion déposé sur un substrat diélectrique comportant un plan de masse, destiné à recevoir des composants micro électroniques, suivant lequel :

    (a) on dépose, sur le substrat diélectrique (10) portant les pistes (14), au moins deux motifs capacitifs de test ($16_1$, $16_2$) ayant des surfaces différentes ($S_1$, $S_2$) et un motif conducteur de test (18) ayant la même largeur que les pistes,

    (b) on mesure les capacités ($C_1$, $C_2$, $C_r$) des motifs capacitifs et conducteur,

    (c) à partir des capacités ($C_1$, $C_2$) des motifs capacitifs on calcule l'épaisseur (e) du substrat diélectrique (e) entre lesdits motifs et le plan de masse et la constante diélectrique ($\varepsilon$) du substrat,

    (d) à partir de la capacité du motif conducteur ($C_r$) et de la constante diélectrique, on calcule la surface du motif conducteur et on en déduit la largeur des pistes, et

    (e) on mesure la capacité de chaque piste de liaison équipotentielle à contrôler et on la compare à une capacité théorique de ladite liaison équipotentielle, tenant compte des valeurs réelles de la constante diélectrique et de la largeur, précédemment déterminées.

2. Procédé selon la revendication 1, caractérisé en ce qu'on détermine ladite capacité théorique à partir de la longueur de la piste et desdites valeurs réelles.

3. Procédé selon la revendication 1, caractérisé en ce que la capacité théorique est mesurée sur un circuit réputé bon et corrigée pour tenir compte desdites valeurs réelles.

4. Procédé selon la revendication 1, 2 ou 3, caractérisé en ce que, de plus on mesure également la résistance du motif, et à partir de cette résistance, de la largeur précédemment déterminée ainsi que de la résistivité du matériau constitutif de la piste et de sa longueur, l'une et l'autre connues a priori, on calcule l'épaisseur de métallisation qui -du fait que la métallisation est effectuée globalement- est également celle des pistes équipotentielles, ou du moins celle des pistes situées à proximité du motif conducteur.

5. Circuit d'interconnexion permettant de mettre en oeuvre le procédé suivant la revendication 1, caractérisé en ce qu'il comporte, en plus de pistes conductrices (14) de liaison équipotentielle ménagées sur un substrat diélectrique comportant un plan de masse,
    - au moins deux motifs capacitifs de test ($16_1$, $16_2$) ayant des surfaces différentes (S1, S2), reliées à des plots de référence (24,26),
    - au moins un motif conducteur de test (18) ayant la même largeur que les pistes conductrices et la même constitution, dont les extrémités sont reliées à des plots (28) placés à proximité des premiers, et
    - des plots de signal (22), reliés chacun à l'une des pistes conductrices de liaison équipotentielle et placés à proximité des autres plots.

6. Circuit selon la revendication 5, caractérisé en ce qu'il porte un microcomposant de mesure et de contrôle ayant des entrées d'alimentation, deux plages d'entrée-sortie de signal et des plages raccordées chacune à l'un desdits plots et contient des cellules de mesures analogiques d'au moins la capacité des différentes pistes et motifs et des moyens de multiplexage, permettant de fournir les mesures effectuées à des moyens extérieurs.

7. Circuit selon la revendication 6, caractérisé en ce qu'il comporte de plus une cellule (42) de mesure analogique de la résistance du motif conducteur (18).

8. Circuit selon la revendication 6 ou 7, caractérisé en ce que le microcomposant comporte un convertisseur analogique-numérique (46) et un registre de données (48).

9. Circuit selon la revendication 8, caractérisé en ce que les liaisons du microcomposant avec l'extérieur du circuit se limitent à deux plots métallisés (30) d'entrée-sortie de données, un plot (32) d'amenée de tension d'alimentation, un plot (34) de liaison de masse et éventuellement un plot d'amenée de commande.

FIG.1.

EP 0 636 894 A1

FIG.2.

FIG.3.

EP 0 636 894 A1

MESURE Ce1 a Cen

COMPARAISON DES VALEURS LUES ET THÉORIQUES

CORRECTIONS VALEURS THÉORIQUES

VALEURS THÉORIQUE

DIAGNOSTIQUE INTERCONNEXION

RÉSISTIVITÉ ρ MÉTALLISATION

MESURE R

ÉPAISSEUR h MÉTALLISATION

MESURE Cr

LARGEUR w CONDUCTEURS

DIAGNOSTIQUE TECHNOLOGIQUE

DÉCISION

SUIVI STATISTIQUE

MESURE C2

MESURE C1

ε

ÉPAISSEUR DIÉLECTRIQUE

36

FIG. 4.

FIG.5.

EP 0 636 894 A1

**Office européen des brevets**

## RAPPORT DE RECHERCHE EUROPEENNE

Numero de la demande
EP 94 40 1237

### DOCUMENTS CONSIDERES COMME PERTINENTS

| Catégorie | Citation du document avec indication, en cas de besoin, des parties pertinentes | Revendication concernée | CLASSEMENT DE LA DEMANDE (Int.Cl.5) |
|---|---|---|---|
| X | 11TH IEEE/CHMT INT. ELECTR. MANUF. TECHN. SYMP., Septembre 1991, US pages 434 - 439 O.C.WOODARD SR. 'High Density Interconnect Verification of Unpopulated Multichip Modules' * page 435, colonne de gauche, ligne 51 - ligne 62 * * page 435, colonne de droite, ligne 19 - ligne 26 * | 1-5 | G01R31/28 |
| A | IMC 1982 PROCEEDINGS, Mai 1982, JP pages 197 - 199 Y.SUZUKI ET AL. 'Developement of Automated Testing Device for Multilayer Ceramic Substrate' * page 197, colonne de droite, dernier alinéa - page 198, colonne de gauche, alinéa 1; figure 4 * | 1,5 | |
| A | US-A-5 202 640 (R.L.SCHAAF ET AL.) * colonne 2, ligne 56 - ligne 60; figures 1,4 * | 1,5 | **DOMAINES TECHNIQUES RECHERCHES (Int.Cl.5)** G01R |
| A | WO-A-90 04792 (BATH SCIENTIFIC) * page 4, ligne 6 - ligne 15 * * page 6, ligne 7 - ligne 30 * * page 8, ligne 34 - page 9, ligne 8 * | 1,5 | |
| A | 1988 IEEE PROC. ON MICROELECTRONIC TEST STRUCTURES, vol.1, no.1, Février 1988, US pages 114 - 119 C.WEBER 'Standard Defect Monitor' * page 117, colonne de droite, alinéa 3; figures 1,2 * | 1 | |
| X | | 5 | |

-/--

Le présent rapport a été établi pour toutes les revendications

| Lieu de la recherche | Date d'achèvement de la recherche | Examinateur |
|---|---|---|
| BERLIN | 30 Août 1994 | Fritz, S |

CATEGORIE DES DOCUMENTS CITES
X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons
& : membre de la même famille, document correspondant

Office européen
des brevets

**RAPPORT DE RECHERCHE EUROPEENNE**

Numero de la demande

EP 94 40 1237

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int.Cl.5) |
|---|---|---|---|
| A | FR-A-2 296 852 (IBM)<br>* page 5, ligne 19 - ligne 27 *<br>--- | 1 | |
| A | EP-A-0 255 449 (FUJITSU)<br>* colonne 4, ligne 29 - ligne 40; figures 2,1 *<br>* colonne 5, ligne 55 - ligne 61 *<br>----- | 6 | |
| | | | **DOMAINES TECHNIQUES RECHERCHES (Int.Cl.5)** |

Le présent rapport a été établi pour toutes les revendications

| Lieu de la recherche | Date d'achèvement de la recherche | Examinateur |
|---|---|---|
| BERLIN | 30 Août 1994 | Fritz, S |

EPO FORM 1503 03.82 (P04C03)